# EUROPÄISCHE PATENTSCHRIFT

(11) **EP 0 764 984 B1**
(45) Veröffentlichungstag und Bekanntmachung des Hinweises auf die Patenterteilung: **21.10.1998**
(21) Anmeldenummer: 96114001.9
(22) Anmeldetag: 30.08.1996
(51) Int. Cl.: H01L 25/065, H01L 23/32, H01L 25/16, H01L 23/04

(54) **Schutzgehäuse für auf einem Schaltungssubstrat mit Bonddrähten angeordnete Halbleiterchips**
Protection housing for semiconductor chips bonded to a circuit substrate by means of bonding wires
Boîtier de protection pour des puces semi-conductrices reliées à un substrat de circuit au moyen de fils de connexion

(30) Priorität: 08.09.1995 DE 19533300
(43) Veröffentlichungstag der Anmeldung: 26.03.1997
(73) Patentinhaber: SIEMENS AKTIENGESELLSCHAFT, 80333 München (DE)
(72) Erfinder: Drekmeier, Karl-Gerd, 82008 Unterhaching (DE)

(56) Entgegenhaltungen:
- WO-A-92/20096
- DE-A- 3 030 286
- FR-A- 2 288 394
- IBM TECHNICAL DISCLOSURE BULLETIN, Bd. 29, Nr. 8, Januar 1987, NEW YORK, Seiten 3589-3590, XP002027188 "snap-on cap/seal for mcm module"
- RESEARCH DISCLOSURE, Nr. 321, 1.Januar 1991, Seite 34 XP000163454 "LOW PROFILE PACKAGING METHOD"

## Beschreibung

Die Erfindung betrifft ein Schutzgehäuse für mindestens zwei auf einem Schaltungssubstrat angeordnete Halbleiterchips und ihre Bonddrahtverbindungen zur Schaltung.

Zur Miniaturisierung elektronischer Schaltungen, beispielsweise Hybridschaltungen, werden ungehäuste Halbleiterchips auf einem Substrat placiert und mit Leitungen der Schaltung verbunden. Es ist erforderlich, diese "bare chips", die beispielsweise im Zusammenhang mit Leistungsbrücken oder Multichipmodulen verwendet werden, zusammen mit ihren Bonddrahtverbindungen gegen äußere Einflüsse zu schützen.

Bisher wurden zum Schutz hermetisch dichte Metall- oder Keramikgehause eingesetzt, die jedoch großvolumig, kostenintensiv und nach dem Verschluß nicht zerstörungsfrei wieder zu öffnen waren.

IBM Technical Disclosure Bulletin, vol. 29, no. 8, Januar 1987, Seiten 3589-3590 und FR-A-2 288 394 offenbaren entsprechende Schutzgehäuse.

Der Erfindung liegt die Aufgabe zugrunde, ein Schutzgehäuse der eingangs genannten Art zu schaffen, dessen Volumen kleinstmöglich auf den Schutzbereich ausgelegt ist und insbesondere dessen Bauhöhe im Bereich der Standardbauhöhe von durch Umpressen hergestellten Einzelhalbleitergehäusen liegt.

Erfindungsgemäß wird dies bei einem Schutzgehäuse der eingangs genannten Art dadurch erreicht, daß das Schutzgehäuse aus einem durch das Substrat gebildeten Bodenteil, einem darauf aufgeklebten rechteckigen Gehäuserahmen aus Kunststoffmaterial und einem damit lösbar verrastbarem flachen Deckel aus Kunststoffmaterial besteht, daß der Gehäuserahmen deckelseitig eine umlaufende Auflagefläche für den Deckel aufweist, an deren Außenrand abschnittsweise jeweils bis etwa Deckelhöhe emporstehende elastische Stege angeordnet sind, und daß die Stege und der Deckel Mittel zur gegenseitigen Verrastung aufweisen.

Weitere vorteilhafte Ausgestaltungen der Erfindung sind Gegenstand der Unteransprüche.

Die Erfindung wird nun anhand eines Ausführungsbeispiels unter Bezugnahme auf die beigefügte Zeichnung noch näher erläutert. Es zeigen:
- Figur 1 bzw. 2: in einer perspektivischen Aufsicht ein erfindungsgemäßes Schutzgehäuse mit abgenommenen, in Figur 2 dargestelltem Deckel,
- Figur 3: eine Aufsicht vom Substrat her auf den zum Schutzgehäuse gehörenden Gehäuserahmen gemäß Figur 1,
- Figur 4: in seitlich geschnittener Darstellung ein Schutzgehäuse mit aufgesetztem Deckel,
- Figur 5 bzw. Figur 6: eine Seitenansicht bzw. Draufsicht des zum Schutzgehäuse gehörenden Deckels.

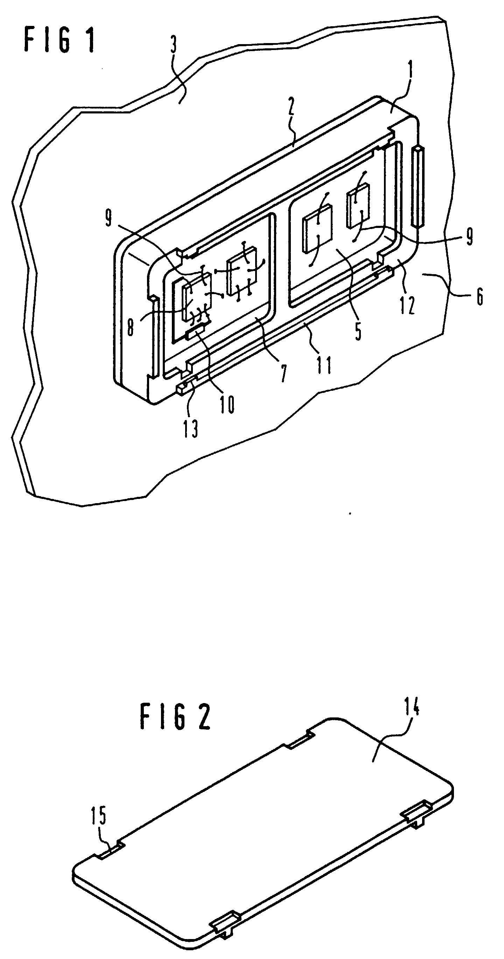

In Figur 1 ist ein rechteckiger, gegebenenfalls natürlich auch quadratisch ausführbarer Gehäuserahmen (1) dargestellt, der mit einem mechanisch streßarmen Kleber (2) auf das als Chipträger dienende Substrat (3) aufgeklebt ist. Die in Figur (3) besser erkennbare umlaufende Dicht- und Klebeflache (4) des Gehäuserahmens (1) paßt sich unter entsprechendem Klebedruck dem Substratoberflächenverlauf, der leicht gewölbt sein kann, an, so daß eine zuverlässige Abdichtung zwischen dem Rahmeninneren (5) und der Rahmenumgebung (6) entsteht. Diese Abdichtung gewährleistet eine reproduzierbare Gießmassenfüllung (7) aus beispielsweise Silicongel, dessen Konsistenz im Verarbeitungszustand wasserähnlich ist. Etwaige Undichtigkeiten würden bedeuten, daß das Füllstandssoll nicht erreicht wird. Durch die Gießmassenfüllung (7) im Rahmeninneren (5) werden die dort angeordneten ungehäusten Chips (8), deren Bonddrähte (9) und beispielsweise auch integrierte Schichtwiderstände (10) auch bei ungünstigen klimatischen und dynamischen Bedingungen noch besser als nur durch das unverfüllte Schutzgehäuse alleine, geschützt. Statische oder manuelle Kräfte, beispielsweise Berührungen, welche direkt auf die Gießmasse (7) einwirken, gefährden die Bonddrähte (9) und die Chips (8). Deshalb, und um bei günstigen Bedingungen bereits ohne Gießmasse einen ausreichenden Schutz zu gewährleisten, wird der Gehäuserahmen mit einem flachen Deckel (14), vgl. Figur 2, verschlossen. Dieser Deckel (14) wird abschnittsweise nach außen durch Stege (11) begrenzt und liegt auf der im wesentlichen umlaufenden Auflagefläche 12 auf.

Innerhalb der Stege (11) befinden sich, wie in Figur 1 erkennbar, Rastnasen 13, die sich beim Aufdrücken des Deckels (14) formschlüssig über die in den Figuren 2,5 und 6 erkennbaren Vertiefungen (15) des Deckels (14) schieben. Beim Einrastvorgang verformen sich nur die Stege (11) elastisch um wenige Zehntel Millimeter nach außen, ohne dabei die Klebeverbindung zwischen dem Substrat und dem Gehauserahmen zu gefährden, da sich nur die Stege (11) und nicht das Schutzgehause als ganzes verformen.

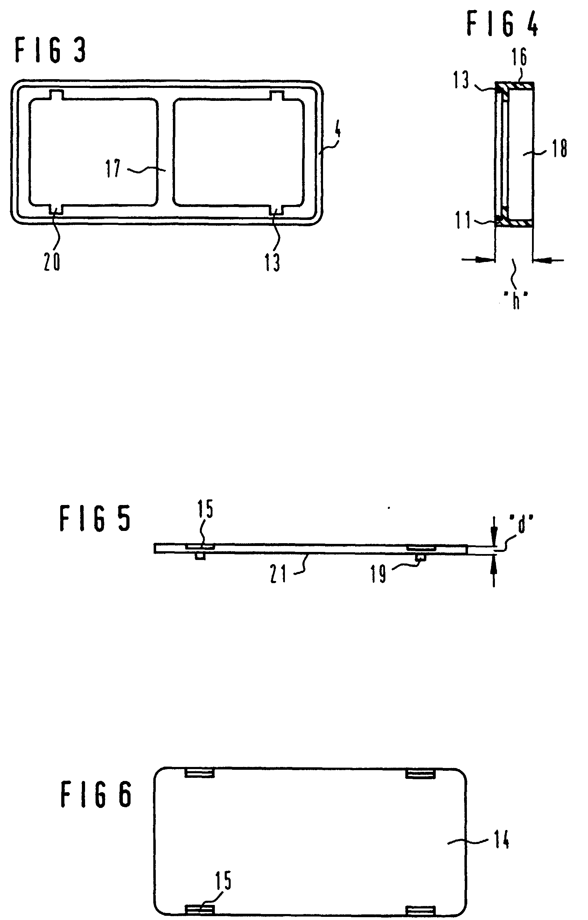

Figur 3 und 4 verdeutlichen die geometrischen Verhältnisse. Das quer- und längsstabile Profil (16), also der Gehauserahmen (1), kann, wie dargestellt, mit einer oder mehreren Stabilisierungsrippen (17) oberhalb des Bauelementeraumes (18) versehen sein. Die Stabilität des Profils (16) ist die Voraussetzung für eine ungefahrdete und trotzdem lösbare Verbindungstechnik zwischen dem Gehauserahmen (1) und dem Deckel (14).

Figur 5 und 6 verdeutlicht die Geometrie des Flachdeckels, dessen Dicke "d" ca. 20% der Rahmenhöhe "h", Figur 4, beträgt. Wie dargestellt, können am Deckel (14) rahmenseitig Druckstücke (19) angeordnet sein, die beim Aufdrücken des Deckels (14) an den Rastnasen (13) entlanggleiten und die Stege (11) so weit nach außen drücken, bis die Rastnasen (13) über den Vertiefungen (15) einrasten, wobei die Druckstücke (19) in Fenster (20) eintauchen, die in der Deckelauflagefläche (21) vorgesehen sind. Nach dem Einrasten entsteht durch eine konvexe Deckelauflagefläche (21) eine Vorspannung zwischen Deckel und Gehäuserahmen, die eine ausreichende Deckelabdichtung, beispielsweise gegenüber Schmutzwasser oder Betauung, bewirkt. Deckel und Gehäuserahmen können beispielsweise aus einem Thermoplast gefertigt sein, das kurzfristig mit mehr als 200°C belastbar und somit reflowfähig ist.

Die besonderen Vorteile der neuen Gehausetechnik liegen darin, daß verschiedene, wählbare Schutzmaßnahmen für Chips und Bonddrähte, also mit und ohne Verguß im Gehäuse möglich sind. Vorteilhaft ist außerdem, daß das Verschließen und auch das zerstörungsfreie Wiederöffnen des Schutzgehäuses mit dem Deckel ohne besondere Hilfsmittel möglich ist. Erwähnenswert sind auch die geringen Herstellkosten des erfindungsgemäßen Schutzgehäuses.

## Patentansprüche

1. Schutzgehäuse für mindestens zwei auf einem Schaltungssubstrat (3) angeordnete Halbleiterchips (8) und ihre Bonddrahtverbindungen (9) zur Schaltung,
**dadurch gekennzeichnet**,
daß das Schutzgehäuse aus einem durch das Substrat (3) gebildeten Bodenteil, einen darauf aufgeklebten, rechteckigen Gehäuserahmen (1) aus Kunststoffmaterial und einem damit lösbar verrastbarem Deckel (14) aus Kunststoffmaterial besteht, daß der Gehäuserahmen (1) deckelseitig eine umlaufende Auflagefläche (12) für den Deckel (14) aufweist, an deren Außenrand abschnittsweise jeweils bis etwa Deckelhöhe emporstehende elastische Stege (11) angeordnet sind, und daß die Stege (11) und der Deckel (14) Mittel (13, 15) zur gegenseitigen Verrastung aufweisen.

2. Schutzgehäuse nach Anspruch 1,
**dadurch gekennzeichnet**,
daß der Gehäuserahmen (1) bodenseitig als umlaufende Dicht- und Klebeflache (4) ausgebildet ist.

3. Schutzgehäuse nach Anspruch 1 oder 2,
**dadurch gekennzeichnet,**
daß an der Innenseite der Stege (11) Rastnasen (13) angeordnet sind, die sich beim Aufdrücken des Deckels (14) formschlüssig über in dessen Randbereich angebrachte Vertiefungen (15) schieben.

4. Schutzgehäuse nach Anspruch 3,
**dadurch gekennzeichnet,**
daß am Deckel (14) rahmenseitig Druckstücke (19) angeordnet sind, die beim Aufdrücken des Deckels (14) an den Rastnasen (13) entlanggleiten und die Stege (11) so weit nach außen drücken, bis die Rastnasen (13) über den Vertiefungen (15) einrasten, wobei die Druckstücke (19) in Fenster (20) eintauchen, die in der Deckelauflagefläche (21) vorgesehen sind.

5. Schutzgehäuse nach einem der Ansprüche 1 bis 4,
**dadurch gekennzeichnet,**
daß der Gehauserahmen (1) mindestens eine oberhalb des Bauelementeraumes (18) angeordnete Stabilisierungsrippe (17) aufweist.

6. Schutzgehäuse nach einem der Ansprüche 1 bis 5,
**dadurch gekennzeichnet**,
daß das Innere des Schutzgehäuses mit Gießmasse (7) verfüllt ist.

## Claims

1. Protective housing for at least two semiconductor chips (8) arranged on a circuit substrate (3) and their bonding wire connections (9) to the circuit,
characterized in that the protective housing comprises a base part formed by the substrate (3), a rectangular housing frame (1) made of plastic material and bonded on to the said base part, and a cover (14) made of plastic material, which cover can be latched together with the said frame in a manner that allows it to be released, in that on the cover side the housing frame (1) has a peripheral bearing surface (12) for the cover (14), elastic webs (11) each projecting up to about the height of the cover being arranged in sections on the outer edge of the said bearing surface, and in that the webs (11) and the cover (14) have means (13,15) for mutual latching.

2. Protective housing according to Claim 1,
characterized in that on the base side the housing frame (1) is designed as a peripheral sealing and bonding surface (4).

3. Protective housing according to Claim 1 or 2,
characterized in that latching lugs (13) are arranged on the inner side of the webs (11) and, when the cover (14) is pressed on, move in a positively locking manner over depressions (15) provided in the edge region of the said cover.

4. Protective housing according to Claim 3,
characterized in that pressure pieces (19) are arranged on the frame side of the cover (14) and, when the cover (14) is pressed on, slide along the latching lugs (13) and force the webs (11) outwards until the latching lugs (13) latch into place over the depressions (15), the pressure pieces (19) descending into windows (20) provided in the cover bearing surface (21).

5. Protective housing according to one of Claims 1 to 4,
characterized in that the housing frame (1) has at least one stabilization rib (17) arranged above the component space (18).

6. Protective housing according to one of Claims 1 to 5,
characterized in that the interior of the protective housing is filled with casting compound (7).

## Revendications

1. Boîtier de protection pour au moins deux puces semi-conductrices (8) disposées sur un substrat de circuit (3) et leurs fils de connexion (9) au circuit, caractérisé en ce que le boîtier de protection est composé d'une partie de fond formée par le substrat (3), d'un bâti de boîtier (1) rectangulaire en matière plastique, collé sur ladite partie de fond, et d'un couvercle (14) amovible en matière plastique, enclenchable dans ledit bâti de boîtier, en ce que le bâti de boîtier (1), côté couvercle, comporte une surface d'appui (12) continue destinée au couvercle (14), à la périphérie de laquelle sont disposées, par tronçons, des ailettes (11) élastiques se dressant vers le haut, chacune approximativement jusqu'au niveau du couvercle, et en ce que les ailettes (11) et le couvercle (14) comportent des moyens (13, 15) leur permettant de s'enclencher l'un dans l'autre.

2. Boîtier de protection selon la revendication 1, caractérisé en ce que le bâti de boîtier (1), côté fond, est réalisé sous forme de surface étanche et adhésive (4) continue.

3. Boîtier de protection selon la revendication 1 ou 2, caractérisé en ce que des taquets d'arrêt (13) sont disposés sur la face interne des ailettes (11), qui, lors de l'application du couvercle (14), se glissent sur des creux (15) ménagés à la périphérie de celui-ci et s'y engagent.

4. Boîtier de protection selon la revendication 3, caractérisé en ce que des éléments-poussoirs (19) sont disposés sur le couvercle (14), côté bâti, qui, lors de l'application du couvercle (14), glissent le long des taquets d'arrêt (13) et poussent les ailettes (11) vers l'extérieur, jusqu'à ce que les taquets d'arrêt (13) s'enclenchent au-dessus des creux (15), les éléments-poussoirs (19) s'enfonçant dans des fenêtres (20) prévues dans la surface d'appui (21) destinée au couvercle.

5. Boîtier de protection selon l'une des revendications 1 à 4, caractérisé en ce que le bâti de boîtier (1) comporte au moins une nervure stabilisatrice (17) disposée au-dessus du compartiment des composants (18).

6. Boîtier de protection selon l'une des revendications 1 à 5, caractérisé en ce que l'intérieur du boîtier de protection est rempli d'une masse de coulée (7).
